Europäisches Patentamt

European Patent Office

Office européen des brevets

(19)

(11) Veröffentlichungsnummer : **0 479 307 B1**

## (12) EUROPÄISCHE PATENTSCHRIFT

(45) Veröffentlichungstag der Patentschrift :
26.04.95 Patentblatt 95/17

(51) Int. Cl.$^6$ : **H01L 33/00**

(21) Anmeldenummer : **91116960.5**

(22) Anmeldetag : **04.10.91**

(54) **Infrarotes Licht emittierende Diode.**

(30) Priorität : **04.10.90 DE 4031290**

(43) Veröffentlichungstag der Anmeldung :
**08.04.92 Patentblatt 92/15**

(45) Bekanntmachung des Hinweises auf die
Patenterteilung :
**26.04.95 Patentblatt 95/17**

(84) Benannte Vertragsstaaten :
**DE FR GB IT**

(56) Entgegenhaltungen :
**EP-A- 0 115 204**
**US-A- 4 477 824**
**PATENT ABSTRACTS OF JAPAN vol. 7, no.**
**264 (E-212)(1409) 24. November 1983 &**
**JP-A-58 147 084**
**PATENT ABSTRACTS OF JAPAN vol. 7, no.**
**115 (E-176)(1260) 19. Mai 1983 & JP-A-58 034**
**984**

(73) Patentinhaber : **TEMIC TELEFUNKEN**
**microelectronic GmbH**
**Theresienstrasse 2**
**D-74072 Heilbronn (DE)**

(72) Erfinder : **Bommer, Ulrich, Dipl.-Ing.**
**Kapellenweg 24**
**W-7519 Eppingen-Rohrbach (DE)**
Erfinder : **Schairer, Werner, Dr. Dipl.-Phys.**
**Masurenweg 1**
**W-7102 Weinsberg (DE)**

(74) Vertreter : **Maute, Hans-Jürgen, Dipl.-Ing.**
**TEMIC TELEFUNKEN microelectronic GmbH**
**Postfach 35 35**
**D-74025 Heilbronn (DE)**

## Beschreibung

Die Erfindung betrifft eine epitaktische Halbleiterschichtenfolge auf einem Halbleitersubstrat zur Verwendung bei der Herstellung infrarot-emittierender Dioden. Insbesondere betrifft die Erfindung eine epitaktische Halbleiterschichtenfolge aus GaAlAs-Mischkristall.

Aus "Light Emitting Diodes, Prentice/Hall International 1987", S. 117 ff., ist bekannt, Halbleiterdioden wegen der verbesserten Lichtausbeute aus epitaktischen GaAlAs-Mischkristallen herzustellen. Dazu wird auf ein n-dotiertes GaAs-Halbleitersubstrat im Flüssigphasenepitaxieverfahren siliziumdotiertes GaAlAs aufgewachsen. Die Temperatur der Schmelze wird von einer hohen Temperatur zu Beginn des epitaktischen Wachstums auf eine niedrigere Temperatur abgesenkt. Die hohe Temperatur hat zur Folge, daß das Silizium zunächst eine n-Dotierung der epitaktischen Schicht bewirkt. Bei einer kritischen Temperatur ändert sich der Leitungstyp der epitaktischen Schicht von n nach p. Es entsteht der pn-Übergang. Gleichzeitig hat sich der Aluminium-Gehalt in der aufgewachsenen Schicht vom Substrat zur Oberfläche hin ständig verkleinert, weil die Schmelze an Al verarmt.

Nun wird das Halbleitersubstrat mit einer Stoppätze entfernt und die Diode kontaktiert, wobei die Fläche, die zuvor die Grenzfläche zum Substrat bildete, nunmehr die lichtemittierende Fläche darstellt. Die Entfernung des Substrats ist notwendig, um die Lichtemission an der freigegebenen GaAlAs-Oberfläche zu ermöglichen.

Das Entfernen des Substrats ist technisch sehr aufwendig und daher teuer. Die zurückbleibenden dünnen Epitaxieschichten sind sehr bruchempfindlich bei der Handhabung für die Weiterverarbeitung. Zusätzlich erweist sich die Kontaktierung infolge des hohen Al-Anteils als schwierig.

Der Erfindung liegt daher die Aufgabe zugrunde, eine Halbleiteranordnung bestehend aus GaAlAs auf einem Halbleitersubstrat anzugeben, die Verwendung findet bei der Herstellung infrarot-emittierender Dioden, deren Substratschicht bei der Diodenherstellung erhalten werden kann.

Diese Aufgabe wird gelöst durch die Merkmale des Anspruchs 1. Die weitere vorteilhafte Ausgestaltung der Erfindung ergibt sich aus den Unteransprüchen.

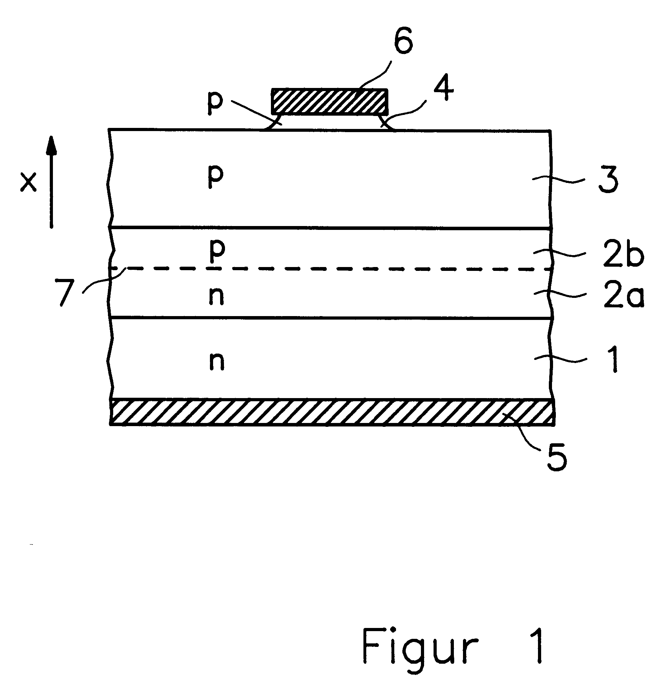

Im folgenden wird die Erfindung anhand der Figuren 1 bis 3 erläutert.

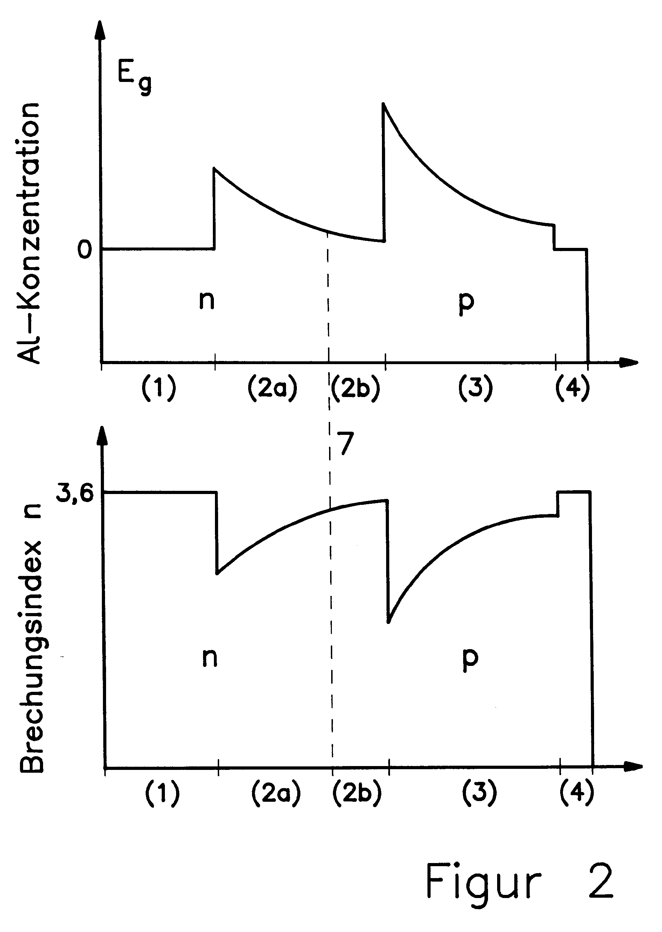

Figur 1 zeigt ein erfindungsgemäßes Halbleiterbauelement. Das Halbleiterbauelement besteht aus einem Rückseitenkontakt 5, vorzugsweise aus Au:Ge, dem n-dotierten GaAs-Halbleitersubstrat 1, der zu beschreibenden Epitaxieschichtenfolge 2a, 2b, 3, 4 und der stegartig ausgebildeten Oberflächenkontaktierung 6, die vorzugsweise aus Al besteht. Die Schichtenfolge beinhaltet eine erste epitaktische Schicht 2a, 2b mit einer n-leitenden Zone 2a und einer p-leitenden Zone 2b. Die n-leitende Zone 2a ist 20 bis 100 µm stark und weist einen Al-Anteil von 1,5 bis 80 % an der Grenzfläche zum Substrat und einen weiteren Verlauf über die Dicke der Schicht 2a, 2b gemäß Figur 2 auf. Die p-leitende Zone 2b ist ca. 5 bis 50 µm dick und zeichnet sich dadurch aus, daß sich in ihr der Verlauf der Aluminium-Konzentration von der n-leitenden Zone 2a her stetig fortsetzt.

Die zweite Schicht 3 ist p-leitend, ca. 10 bis 80 µm dick und weist einen Al-Anteil an der Grenzfläche zur darunterliegenden Schicht 2b von 10 bis 80 % auf. Der Al-Anteil ist so zu wählen, daß er größer ist als der Al-Anteil der ersten Schicht 2a an der Grenzfläche zum Substrat 1. Darüber hinaus sollte der Al-Anteil am pn-Übergang 7 nicht größer sein als an der dem pn-Übergang abgewandten Oberfläche der zweiten Schicht 3. Da der Kontaktwiderstand von metallischen Kontakten auf GaAlAs-Mischkristallen sehr stark von der Aluminium-Konzentration abhängt und umso höher ausfällt, je höher der Al-Anteil in GaAlAs ist, kann auf diese zweite Schicht 3 zur Verbesserung des Kontaktierverhaltens eine hochdotierte p-leitende GaAs-Schicht 4 aufgewachsen werden, deren Dicke so zu wählen ist, daß ein niederohmiger Kontakt realisiert werden kann. Eine typische Dicke von 0,1 bis 5 µm ist ausreichend. Der so hergestellte Kontakt 6 zeichnet sich durch einen kleinen Widerstandswert und gute Reproduzierbarkeit bei der Herstellung aus.

Figur 2 (oben) zeigt den Verlauf der Aluminium-Konzentration über dem Querschnitt in einem erfindungsgemäßen Halbleiterbauelement. Der Bandabstand $E_g$ ist direkt proportional zur Aluminium-Konzentration, und deshalb ebenfalls in Figur 2 aufgetragen. Die Aluminium-Konzentration, und damit auch der Bandabstand, steigt beim Übergang vom Al-freien Substrat 1 zur ersten epitaktischen Schicht 2a sprunghaft an und fällt dann innerhalb der ersten epitaktischen Schicht 2a, 2b annähernd exponentiell ab. Beim Übergang zur zweiten epitaktischen Schicht 3 nimmt die Aluminium-Konzentration wieder sprunghaft zu, um innerhalb der Schicht 3 wieder annähernd exponentiell abzufallen. Die dritte epitaktische Schicht 4 ist frei von Aluminium, so daß beim Übergang von der zweiten epitaktischen Schicht 3 zur dritten epitaktischen Schicht 4 die Aluminium-Konzentration sprunghaft abfällt. Das Aluminium-Konzentrationsprofil innerhalb der ersten epitaktischen Schicht 2a, 2b und der zweiten epitaktischen Schicht 3 entsteht bei der Herstellung dieser Schichten durch Flüssigphasenepitaxie. Zu Beginn des Wachstums ist die Schmelze reich an Aluminium und es wird infolge des hohen Verteilungskoeffizienten zunächst viel Aluminium in den Mischkristall eingebaut. Dadurch verarmt die Schmelze rasch an Aluminium, so daß die Al-Konzentration in Kristall ebenfalls schnell abnimmt.

Da der pn-Übergang 7 durch amphoterische Si-Dotierung realisiert wird, liegt er innerhalb der ersten epi-

2

taktischen Schicht 2a, 2b. Der Verlauf der Aluminium-Konzentration setzt sich zu beiden Seiten des pn-Übergangs stetig fort. Durch die Einbettung des pn-Übergangs in zwei aluminiumhaltige Zonen wird die Absorption der emittierten Strahlung stark reduziert.

Figur 2 (unten) zeigt den Verlauf des Brechungsindex n in einem erfindungsgemäßen Halbleiterbauelement. Der Brechungsindex n ist abhängig von der Aluminium-Konzentration im Kristall und ist umso kleiner je größer die Aluminium-Konzentration ist. Durch den Verlauf des Brechungsindex im Bereich des pn-Übergangs 7 kommt es zu einem Lichtleiteffekt, wobei die n-dotierte Zone 2a der ersten Epitaxieschicht infolge des Gradienten des Brechungsindex die elektromagnetische Strahlung in Richtung der pn-Übergangsebene 7 ablenkt. Das leistet einen entscheidenden Beitrag zur Verbesserung der Lichtauskopplung parallel zum pn-Übergang 7.

Die Herstellung der Epitaxieschichten erfolgt nach dem bekannten Flüssigphasenepitaxieverfahren. Die Halbleitersubstratscheiben werden zunächst in einer Mischung aus $H_2SO_4$, $H_2O_2$ und $H_2O$ im Verhältnis 8:1:1 gereinigt. Die Ätzzeit beträgt bei einer typischen Temperatur von 60 °C ca. 2 min. Die Kristallorientierung der Substrate ist vorteilhaft <100> oder <111>, wobei in diesem Beispiel von der 100-Orientierung ausgegangen wird. Die Zusammensetzung der einzelnen Epitaxieschmelzen hängt im einzelnen von der gewünschten Dotierung, der angestrebten Schichtdicke, dem erforderlichen Aluminium-Profil und der Epitaxietemperatur ab. Diese Parameter sind auf hohe Ausgangsleistung des herzustellenden Halbleiterbauelements zu optimieren. Die Einwaagen der folgenden Bestandteile der jeweiligen Epitaxieschmelze beziehen sich jeweils auf den Gallium-Grundbestandteil. Die erste Schmelze für die erste Epitaxieschicht 2a, 2b enthält 5,5 bis 6,5 % GaAs, 0,03 bis 0,2 % Aluminium, 0,7 bis 0,8 % Silizium. Die zweite Schmelze für die zweite Epitaxieschicht 3 enthält 2,5 bis 3,5 % GaAs, 0,1 bis 0,3 % Aluminium und 0,6 bis 0,7 % Germanium oder einem anderen p-Dotierstoff wie Zink, Magnesium oder Silizium. Die dritte Schmelze zum Aufwachsen der GaAs-Schicht 4 zur Verbesserung der Kontaktiereigenschaften enthält 0,9 % GaAs und 0,8 % Germanium bzw. dem Dotierstoff der zweiten Schmelze.

Die genauen Zusammensetzungen der Epitaxieschmelzen für zwei explizite Beispiele a und b sind aus der Tabelle 1 zu entnehmen.

| Beispiel | Schmelze Nr. | GaAs% | Al% | Si% | Ge% |
|----------|--------------|-------|------|------|------|
|          | 1            | 6,2   | 0,05 | 0,75 |      |
| a        | 2            | 3,3   | 0,2  | -    | 0,65 |
|          | 3            | 1,6   | -    | -    | 0,8  |
|          | 1            | 5,7   | 0,14 | 0,75 |      |
| b        | 2            | 2,8   | 0,2  | -    | 0,62 |
|          | 3            | 0,9   | -    | -    | 0,8  |

Tabelle 1

Die Schmelzen werden in die vorgesehenen Behälter des Epitaxiebootes gefüllt und das Boot in den Epitaxiereaktor eingebracht. Die Temperatur im Reaktor wird auf die erste Haltetemperatur T1 (ca. 400 °C) erhöht und für ca. 30 min gehalten. Bei dieser Temperatur zersetzen sich eventuell vorhandene Galliumoxidreste auf den Substratscheiben und im Epitaxieboot.

Bei der zweiten Haltetemperatur T2 (ca. 1000 °C) lösen sich sämtliche Einwaagen in den Schmelzen und gleichzeitig werden die Schmelzen homogenisiert.

Von nun an wird die Temperatur im Epitaxiereaktor kontinuierlich mit einer Abkühlrate von 0,8 bis 1 °C pro Minute abgesenkt.

Beim Erreichen der Temperatur T3 (ca. 900 - 920 °C) werden die Substratscheiben in die erste Schmelze eingetaucht. Es wächst zunächst eine n-leitende GaAlAs-Schicht 2a auf, deren Al-Anteil beständig abnimmt (Figur 2). Bei ca. 878 °C erfolgt der Umschlag von n- zur p-Leitung. Der pn-Übergang wird somit in einer Schmelze und in einem Prozeßschritt erzeugt. Nun wächst die n-leitende Zone 2b der ersten epitaktischen Schicht auf. Der Al-Anteil im Kristall nimmt weiterhin ab.

Bei der Temperatur T4 (ca. 840 bis 870 °C) werden die Scheiben aus der ersten Schmelze entnommen und in die zweite Schmelze eingetaucht. Es wächst nun eine p-leitende GaAlAs-Schicht auf, deren Al-Anteil an der Grenzfläche zur zuvor aufgewachsenen Schicht höher ist als der Al-Anteil der zuvor aufgewachsenen Schicht an der Grenzfläche zum Substrat.

Nachdem die gewünschte Schichtdicke aufgewachsen ist, werden bei einer Temperatur T5 (ca. 720 bis 790 °C) die Scheiben aus der zweiten Schmelze herausgenommen. Soll keine weitere Epitaxieschicht aufgewachsen werden, so wird der Epitaxiereaktor auf Umgebungstemperatur abgekühlt. Ansonsten wird noch eine p-leitende GaAs-Epitaxieschicht zur Verbesserung der Kontakteigenschaften aufgewachsen. Dazu werden die Substratscheiben in die dritte Schmelze eingetaucht, die bei der Temperatur T5 näherungsweise gesättigt mit As ist. Nach dem Aufwachsen einer Schicht mit einer typischen Dicke im Bereich von 0,4 bis 4 $\mu$m entfernt man die Scheiben aus der Schmelze. Der Epitaxiereaktor wird auf Umgebungstemperatur abgekühlt.

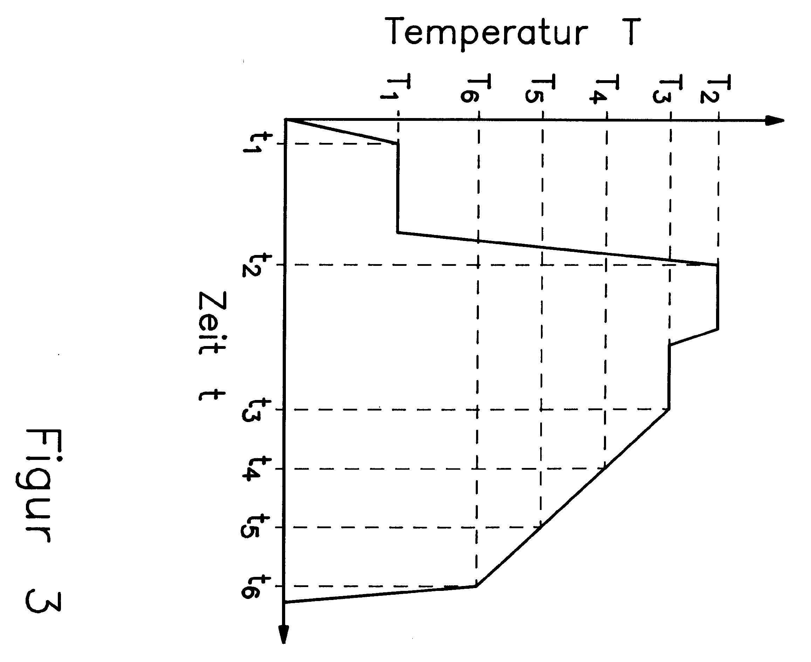

Der Temperaturverlauf des Epitaxieprozesses ist in Figur 3 dargestellt. Die genauen Temperaturen T1 bis T6 für die beiden expliziten Beispiele a und b können der Tabelle 2 entnommen werden.

| Beispiel | T1 | T2 | T3 | T4 | T5 | T6 |
|----------|------|-------|------|------|------|------|
| a | 400° | 1000° | 915° | 865° | 776° | 764° |
| b | 400° | 1000° | 915° | 850° | 730° | 715° |

Tabelle 2

In Tabelle 3 sind die Schichtdicken und die Aluminium-Konzentrationen für die beiden Ausführungsbeispiele a und b angegeben. Al1 gibt die Aluminium-Konzentration an der dem Substrat zugewandten Seite, Al2 die Aluminium-Konzentration an der dem Substrat abgewandten Seite der jeweiligen Schicht an.

| Beispiel | Epitaxie-schicht | Al1 in % | Al2 in % | Dicke in $\mu$m |
|----------|---------|------|------|------|
| a | 2a | 5 | 1,8 | 30 |
| | 2b | 1,8 | 1,2 | 15 |
| | 3 | 20 | 4 | 50 |
| | 4 | 0 | 0 | 3 |
| b | 2a | 14 | 5,2 | 30 |
| | 2b | 5,2 | 3,6 | 15 |
| | 3 | 20 | 4 | 50 |
| | 4 | 0 | 0 | 3 |

Tabelle 3

Die Halbleiterelemente werden in einem sich anschließenden Prozeßschritt kontaktiert. Die Rückseite wird flächig oder strukturiert mit Au:Ge beschichtet. Auf die Oberseite der Halbleiteranordnung wird eine stegartig strukturierte Aluminium-Schicht aufgebracht. Ist auf der Oberseite die kontaktfördernde GaAs-Schicht vorhanden, so wird das GaAs außerhalb des Kontaktbereichs mit einer Stoppätze, wie z. B. einer Mischung $H_2O_2$, $NH_4OH$ und $H_2O$, nach der Kontaktstrukturierung wieder abgeätzt.

Nach dem Zerteilen der Halbleiterscheiben und dem Einbau der Chips in ein für Infrarotdioden typisches 5 mm-Gehäuse erhält man folgende Emissionsleistungen:

| Beispiel | $\phi_e$/mW $I_F = 100$ mA | $U_F$/V $I_F = 1,5$ A | $\lambda_p$/nm |
|----------|------|------|------|
| a | 26,5 | 2,2 | 930 |
| b | 22,0 | 2,4 | 900 |

Tabelle 4

Die Leistung, insbesondere des Beispiels a, entspricht der Leistung der eingangs beschriebenen Diode (Stand der Technik) bei weit verbesserter Produzierbarkeit.

Bekannte GaAs-Dioden ohne Al emittieren typische Leistungen um $\phi_e$ (100 mA) = 15 mW.

**Patentansprüche**

1. Halbleiteranordnung mit einer epitaktischen Halbleiterschichtenfolge auf einem Halbleitersubstrat (1) aus einkristallinem GaAs vom n-Leitungstyp, insbesondere zur Verwendung als strahlungsemittierende Diode, wobei sich auf dem Halbleitersubstrat (1) eine erste silizium-dotierte epitaktische GaAlAs-Schicht (2a, 2b) befindet, deren Aluminiumanteil an der Grenzfläche zum Halbleitersubstrat (1) 1,5 - 80 % beträgt und stetig über die Dicke der Schicht abnimmt, wobei die erste Schicht (2a, 2b) eine erste Zone (2a) vom n-Leitungstyp und eine zweite Zone (2b) vom p-Leitungstyp aufweist und wobei sich auf der ersten epitaktischen GaAlAs-Schicht (2a, 2b) eine zweite epitaktische GaAlAs-Schicht (3) vom p-Leitungstyp befindet, deren Aluminiumanteil an der Grenzfläche zur ersten epitaktischen GaAlAs-Schicht (2a, 2b) 10 - 80 % beträgt, dabei dort größer ist als der Aluminiumanteil der ersten epitaktischen Schicht (2a,2b) an der Grenzfläche zum Substrat (1) und über die Dicke der Schicht abnimmt.

2. Halbleiteranordnung nach Anspruch 1, dadurch gekennzeichnet, daß die p-Dotierung der zweiten epitaktischen GaAlAs-Schicht (3) mit Ge vorgenommen wird.

3. Halbleiteranordnung nach Anspruch 1 oder 2, dadurch gekennzeichnet, daß der Aluminiumanteil der zweiten epitaktischen GaAlAs-Schicht (3) an der Grenzfläche zur ersten epitaktischen GaAlAs-Schicht (2a, 2b) 25 - 50 % beträgt.

4. Halbleiteranordnung nach einem der Ansprüche 1 bis 3, dadurch gekennzeichnet, daß die Al-Konzentration am pn-Übergang (7) 0,2 - 30 % beträgt.

5. Halbleiteranordnung nach einem der Ansprüche 1 bis 4, dadurch gekennzeichnet, daß die Al-Konzentration an der dem pn-Übergang (7) abgewandten Oberfläche der zweiten epitaktischen Schicht (3) 2 - 30 % beträgt.

6. Halbleiteranordnung nach einem der Ansprüche 1 bis 5, dadurch gekennzeichnet, daß die Al-Konzentration an der dem pn-Übergang (7) abgewandten Oberfläche der zweiten epitaktischen Schicht (3) größer ist als die Al-Konzentration am pn-Übergang (7).

7. Halbleiteranordnung nach Anspruch 1 oder 6, dadurch gekennzeichnet, daß die Dicke der ersten epitaktischen GaAlAs-Schicht (2a, 2b) 20 - 150 µm beträgt, wobei die erste Zone (2a) ca. 40 µm und die zweite Zone (2b) ca. 20 µm dick ist.

8. Halbleiteranordnung nach einem der vorangegangenen Ansprüche, dadurch gekennzeichnet, daß bei der Verwendung der Halbleiteranordnung als Infrarotdiode die Kontakte (5, 6) auf der Rückseite des Substrats flächig oder strukturiert (5) und auf der obersten epitaktischen Schicht als Steg (6) ausgebildet sind.

9. Halbleiteranordnung nach einem der Ansprüche 1 bis 8, dadurch gekennzeichnet, daß sich zwischen der zweiten epitaktischen GaAlAs-Schicht (3) und der Oberseitenkontaktierung (6) eine weitere epitaktische Schicht aus GaAs vom p-Leitungstyp (4) befindet, die mit Germanium, Silizium, Magnesium oder Zink dotiert ist und die eine Dicke von 0,1 bis 5 µm aufweist und die außerhalb des Kontaktbereichs weggeätzt ist.

## Claims

1. A semiconductor arrangement with an epitaxial semiconductor layer sequence on a semiconductor substrate (1) composed of monocrystalline GaAs of the n-conductivity type, in particular for use as radiation-emitting diode, wherein on the semiconductor substrate (1) there is arranged a first silicon-doped, epitaxial GaAlAs-layer (2a, 2b), the aluminium component of which amounts to 1.5 - 80% at the boundary surface to the semiconductor substrate 1 and decreases constantly over the thickness of the layer, where the first layer (2a, 2b) possesses a first zone (2a) of the n-conductivity type and a second zone (2b) of the p-conductivity type, and where on the first, epitaxial GaAlAs layer (2a, 2b) there is arranged a second epitaxial GaAlAs layer (3) of the p-conductivity type, the aluminium component of which amounts to 10 - 80 % at the boundary surface to the first epitaxial GaAlAs layer (2a, 2b), and here is greater than the aluminium component of the first epitaxial layer (2a, 2b) at the boundary surface to the substrate (1), and decreases over the thickness of the layer.

2. A semiconductor arrangement as claimed in Claim 1, characterised in that the p-doping of the second epitaxial GaAlAs layer (3) is carried out using Ge.

3. A semiconductor arrangement as claimed in Claim 1 or 2, characterised in that the aluminium component of the second epitaxial GaAlAs layer (3) amounts to 25 - 50 % at the boundary surface to the first epitaxial GaAlAs layer (2a, 2b).

4. A semiconductor arrangement as claimed in one of Claims 1 to 3, characterised in that the Al-concentration at the pn-junction (7) amounts to 0.2 - 30%.

5. A semiconductor arrangement as claimed in one of Claims 1 to 4, characterised in that the Al-concentration at the surface of the second epitaxial layer (3) facing away from the pn-junction (7) amounts to 2 - 30%.

6. A semiconductor arrangement as claimed in one of Claims 1 to 5, characterised in that the Al-concentration at the surface of the second epitaxial layer (3) facing away from the pn-junction (7) is greater than the Al-concentration at the pn-junction(7).

7. A semiconductor arrangement as claimed in Claim 1 or 6, characterised in that the thickness of the first epitaxial GaAlAs-layer (2a, 2b) amounts to 20 - 150 µm, where the first zone (2a) is approximately 40 µm thick and the second zone (2b) is approximately 20 µm thick.

8. A semiconductor arrangement as claimed in one of the preceding claims, characterised in that when the semiconductor arrangement is used as infrared diode, the contacts (5, 6) on the rear side of the substrate are planar or structured (5) and on the uppermost epitaxial layer have the form of a rib (6).

9. A semiconductor arrangement as claimed in one of Claims 1 to 8, characterised in that between the second epitaxial GaAlAs layer (3) and the upper-side contact (6) is arranged a further epitaxial layer consisting of GaAs of the p-conductivity type (4) which is doped with germanium, silicon, magnesium or zinc and which possesses a thickness of 0.1 to 5 µm and is etched away outside of the contact zone.

**Revendications**

1. Dispositif à semiconducteurs comportant une succession de couches semiconductrices épitaxiales sur un substrat semiconducteur (1) en GaAs monocristallin de conductivité de type n, en particulier pour l'utilisation en tant que diode émettrice de rayonnement, dans lequel sur le substrat semiconducteur (1) se trouve une première couche épitaxiale GaAlAs (2a, 2b) dopée au silicium, dont la teneur en aluminium à la surface limite avec le substrat semiconducteur (1) s'élève à 1,5-80% et décroît continûment sur l'épaisseur de la couche, la première couche (2a, 2b) présentant une première zone (2a) de type de conductivité n et une seconde zone (2b) de conductivité p et dans lequel sur la première couche épitaxiale GaAlAs (2a, 2b) se trouve une seconde couche épitaxiale GaAlAs (3) de type de conductivité p, dont la teneur en aluminium à la surface limite par rapport à la première couche épitaxiale GaAlAs (2a, 2b) s'élève à 10-80%, et est supérieure à la teneur en aluminium de la première couche épitaxiale (2a, 2b) à la surface limite avec le substrat (1) et décroît sur l'épaisseur de la couche.

2. Dispositif à semiconducteurs selon la revendication 1, caractérisé en ce que le dopage p de la seconde couche épitaxiale GaAlAs (3) est effectué à l'aide de Ge.

3. Dispositif à semiconducteurs selon la revendication 1 ou 2, caractérisé en ce que la teneur en aluminium de la seconde couche épitaxiale GaAlAs (3) à la surface limite avec la première couche épitaxiale GaAlAs (2a, 2b) s'élève à 25-50%.

4. Dispositif à semiconducteurs selon l'une des revendications 1 à 3, caractérisé en ce que la concentration en Al à la jonction pn (7) s'élève à 0,2-30%.

5. Dispositif à semiconducteurs selon l'une des revendications 1 à 4, caractérisé en ce que la concentration en Al à la surface éloignée de la jonction pn (7) de la seconde couche épitaxiale (3) s'élève à 2-30%.

6. Dispositif à semiconducteurs selon l'une des revendications 1 à 5, caractérisé en ce que la concentration en Al à la surface éloignée de la jonction pn (7) de la seconde couche épitaxiale (3) est supérieure à la concentration en Al à la jonction pn (7).

7. Dispositif à semiconducteurs selon la revendication 1 ou 6, caractérisé en ce que l'épaisseur de la première couche épitaxiale GaAlAs (2a, 2b) s'élève à 20-150 microns, la première zone (2a) ayant une épaisseur d'environ 40 microns et la seconde zone (2b) d'environ 20 microns.

8. Dispositif à semiconducteurs selon l'une quelconque des revendications précédentes, caractérisé en ce que dans le cas de l'utilisation du dispositif à semiconducteurs en tant que diode infrarouge, les contacts (5, 6) sont plans ou structurés (5) sur le côté postérieur du substrat et sont réalisés sous la forme d'une nervure (6) sur la couche épitaxiale supérieure.

9. Dispositif à semiconducteurs selon l'une des revendications 1 à 8, caractérisé en ce qu'entre la seconde couche GaAlAs épitaxiale (3) et la réalisation de contacts sur le côté supérieur (6) se trouve une autre couche épitaxiale en GaAs de type de conductivité p (4), qui est dopée au germanium, silicium, magnésium ou zinc et présente une épaisseur de 0,1 à 5 microns et qui est gravée à l'extérieur de la zone de contact.

Figur 1

Figur 2

Figur 3